# EUROPEAN PATENT APPLICATION

(11) **EP 2 535 740 A1**
(43) Date of publication of application: **19.12.2012**
(21) Application number: 11741937.4
(22) Date of filing: 10.02.2011
(51) Int. Cl.: G01T 1/29, H01L 31/00

(54) **IONIZING RADIATION DETECTOR SENSITIVE TO THE 2D POSITION**

(30) Priority: 12.02.2010 ES 201030200
(71) Applicant: Consejo Superior De Investigaciones Científicas (CSIC), 28006 Madrid (ES)
(72) Inventor: BASSIGNANA, Daniela, E-08193 Cerdanyola Del Vallés (Bellaterra) Barcelona (ES); LOZANO FANTOBA, Manuel, E-08193 Cerdanyola Del Vallés (Bellaterra) Barcelona (ES); PELLEGRINI, Giulio, E-08193 Cerdanyola Del Vallés (Bellaterra) Barcelona (ES)
(74) Representative: Ungria López, Javier
(86) International application number: PCT/ES2011/070088
(87) International publication number: WO 2011/098650

(57) **Abstract**

The subject matter of the present invention is a detector (1) which makes it possible to detect both the presence of ionizing radiation and the position thereof in a two-dimensional plane. The detector (1) comprises a semiconductor crystal (2) with an electrode on one of the faces thereof, wherein the opposite face comprises another electrode formed by a plurality of microtracks (P₁-P₆), characterized in that each microtrack (P₁-P₆) comprises a layer of resistive material (7) and is connected, at both ends, to reading circuits (L₁ₐ, L_{1b}-L₆ₐ, L_{6b}).

## Description

### OBJECT OF THE INVENTION

The subject matter of the present invention is a device which makes it possible to detect both the presence of ionizing radiation and the position thereof in a two-dimensional plane.

### BACKGROUND OF THE INVENTION

There are several types of ionizing radiation detectors widely known in the art, such as for example the high resistivity semiconductor detectors. These detectors are small and depending on the type of material they are made, they can operate at room temperature, which is why they are applicable to many different fields, from the experimentation of high energy physics or experiments in the space up to medical imaging or surveillance of industrial processes.

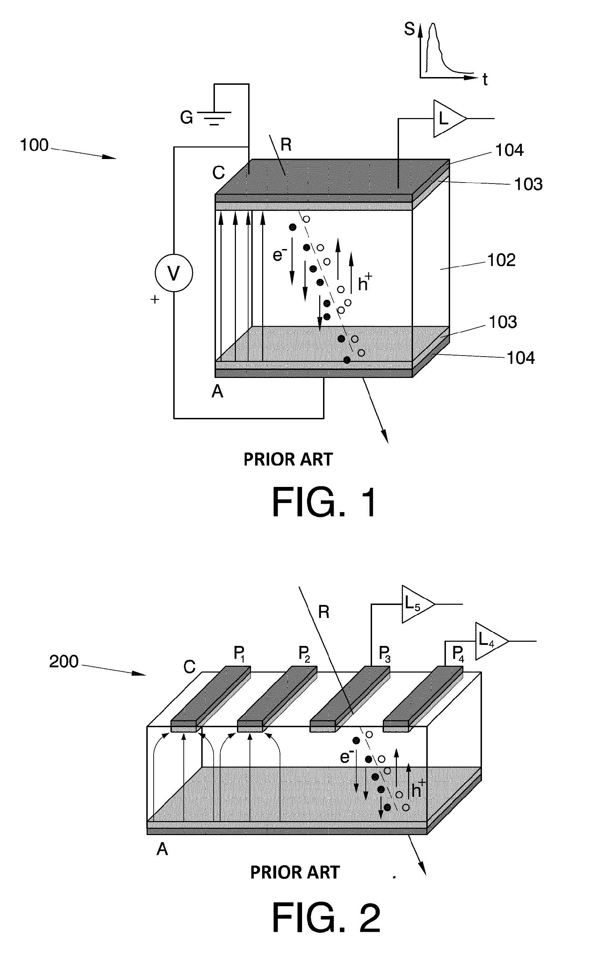

Fig. 1 shows an example of a high resistivity semiconductor radiation detector (100) in accordance with the prior art. This detector is composed of a semiconductor crystal block (102) that has two electrodes, anode (A) and cathode (C), formed in two of their opposing faces by ohmic contacts or rectifiers (103) according to the type of semiconductor used and covered with a metallic material (104). According to a typical configuration, the cathode (C) is connected to ground (G) and to a reading electronic circuit (L) for the processing of the signal, while the anode (A) is connected to an external source of voltage (V). Applying to the electrodes a proper reverse polarization voltage, an electric field is generated in the semiconductor crystal, represented in the figure by means of arrows. When a particle of ionizing radiation (R) passes through the semiconductor crystal (102), it loses energy in the trajectory, creating clouds of electrons (e⁻) and holes (h⁺) that, due to the electric field, move in direction to the anode (A) and to the cathode (C), respectively. This movement of "free charges" generates a charge pulse in the cathode (C) that results into an electrical signal of the type represented in the upper right side of the figure, and that is detectable by the external circuit (L). This radiation detector (100) is only capable of detecting the presence of ionizing radiation, but not its position.

With the object of obtaining information about the position of the event, the so-called microtracks detectors were developed. These detectors, based on the same principles, have one or both electrodes subdivided in stripes or microtracks. Fig. 2 shows an example of microtracks detector (200) where one of the electrodes is divided into four tracks (P₁, _{P2}, P₃, P₄), each of them with a width of the order of 10-30 microns, a length of a few centimetres and a step (distance between the centre of two adjacent tracks) of 25-100 microns. Each of these tracks (P₁-P₄) is essentially an electrode that is independent of the others and that is connected to an independent signal reading circuit (L₄, L₅) (Fig. 2 shows only two of them). In this case, when a particle of ionizing radiation (R) passes, the cloud of charges that moves towards the tracks (P₁-P₄) due to the electric field generates signals more or less intense (of greater or lesser amplitude) based on the proximity of the tracks (P₁-P₄) to the place where the charges have been generated. In this way, we can deduce the position of passage of the particle (R) in the dimension perpendicular to the tracks (P₁-P₄), the resolution being greater the lower the step of the tracks (P₁-P₄). Therefore, this detector (200) provides information about the position in one dimension.

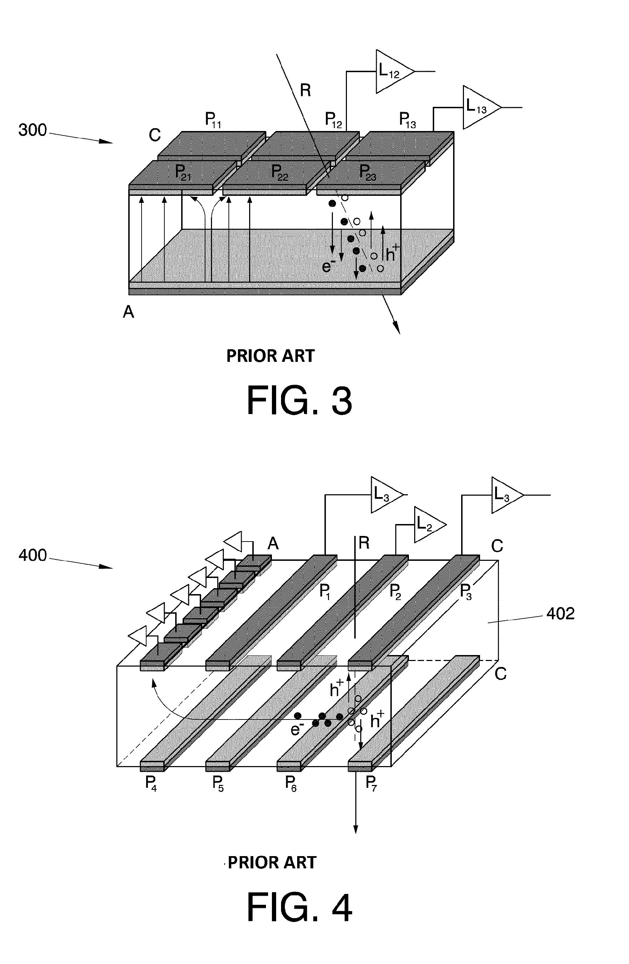

Obviously, the generalization of this concept to two dimensions leads to a radiation detector comprising square tracks (pixels). Fig. 3 depicts a detector (300) the electrodes of which are configured as a square mesh, each of whose elements (P₁₁, P₁₂, P₁₃, P₂₁, P₂₂, P₂₃) is connected to a corresponding reading circuit (L₁₂, L₁₃). Although this detector (300) makes it possible to obtain the position in two dimensions, a more complex reading system is needed, which significantly increases the cost of production.

Another possibility known from the microtrack detectors is the segmentation of the second electrode, which also allows rebuilding a second coordinate. However, segmenting two electrodes has the drawback of requiring a double process of manufacture (one per each side) and the need of a second reading circuit displaced in relation to the first. This results into an increase in the cost of production and of the electronic equipment, as well as an increase in the amount of non-sensitive material used.

There is also another type of radiation detectors sensitive to 2D position developed as an extension of the drift chambers presented by E. Gatti and P. Rehak in "Semiconductor Drift Chamber, An application of a novel charge transport scheme", Nucl. Instr. And Methods in Physics Research, vol. 22, pages 608-614 (1984). This detector (400), depicted in Fig. 4, consists of two sets of parallel microtrack-shaped cathodes (C) (P₁-P₇) located on opposite sides of the semiconductor crystal (402). At the edge of this structure there is an anode (A) divided into a row of elements. When the charge clouds created by the incident radiation (R) move, the holes (h⁺) are quickly collected in the cathode (C), while the electrons (e⁻) go towards the elements that make up the anode (A) along the lines of the field. A coordinate of the event depends on the electrons (e⁻) drift time, while the second coordinate is obtained from the distribution of the signal in the anode (A) elements. As in the case of the double sided microtrack detector, this detector requires a double manufacturing process that dramatically increases the cost of production.

Finally, recently it has been discovered that the semiconductor block of any of the described detectors can be manufactured using materials such as for example, but not limited to CdTe, CdZnTe, SiC, IHg, C, GaN, which do not require any doping implantation for the formation of the electrodes. In other words, in this case each electrode or microtrack would consist only of the metal coating.

### DESCRIPTION OF THE INVENTION

In the present document, when talking about the generation of charges, whether they are electrons or holes, as a result of the passage of ionizing radiation, it shall be said that there has been an "event". The detector object of the present application is a semiconductor detector able to detect the position of a 2D event while maintaining the simplicity of manufacture and the type of electronic of reading of a microtrack detector according to the prior art. The fundamental concept is based on the replacement of the metal material of the detectors of the type described in Fig. 2 with resistive material, in addition to connecting each end of each microtrack to an electronic circuit of independent reading. Moreover, the material of the detector of the invention can also be manufactured using high resistivity semiconductors, such as e.g. CdTe, CdZnTe, SiC, IHg, C or GaN, in which case the microtracks would be formed only by a layer of resistive material.

Indeed, according to the prior art each microtrack has a layer of a metallic material of very low resistivity (e.g., aluminium) and has a single reading circuit connected to one of its ends. As a result, both the amplitude and the time that it takes for a signal generated by an event from the moment it reaches the metal contact of the microtrack until it reaches the corresponding reading electronic circuit is, for practical purposes, independent of the position of the event along said microtrack. However, in a first aspect of the present invention every microtrack of the detector comprises a layer consisting of a resistive material and it has two reading circuits, one connected at each end. Thus, the signal generated as result of an event is transmitted in both directions along the resistive material of the microtrack and is collected at different times and with different amplitude by the two reading circuits located at their ends. Obviously both the attenuation of the signal and the transmission speed along the microtrack depend on the properties of the resistive material used.

Thus, the coordinate parallel to the microtracks can be obtained in two ways, from the time that it takes for a signal with respect to the other to reach the reading circuits located in the ends of a microtrack, or from the difference in form or amplitude of the signals collected by the reading circuits located at the ends of a microtrack. On the other hand, the coordinate perpendicular to the microtracks is obtained in a manner equivalent to the prior art, i.e., based on the amplitude or shape of the signals collected in the different microtracks.

A second aspect of the invention describes a procedure for detecting ionizing radiation in 2D using a detector as the one mentioned above, comprising obtaining the coordinate parallel to the microtracks from the difference in arrival times of each signal to each reading circuit of said microtrack.

A third aspect of the invention describes a procedure for the detection of ionizing radiation in 2D using a detector as the one described above, comprising obtaining the coordinate parallel to the microtracks from the difference of amplitude or shape of the signals collected by reading circuits connected to opposite ends of a microtrack.

### DESCRIPTION OF THE DRAWINGS

Fig. 1 shows a semiconductor detector in accordance with the prior art.
Fig. 2 shows a microtracks detector in accordance with the prior art.
Fig. 3 shows a detector formed by square microtracks in accordance with the prior art.
Fig. 4 shows another type of detector in accordance with the prior art.
Fig. 5 shows a plant view of the detector of the present invention.
Fig. 6 shows a longitudinal section of the detector of the figure 5 along the microtrack P₄.

### PREFERRED EMBODIMENT OF THE INVENTION

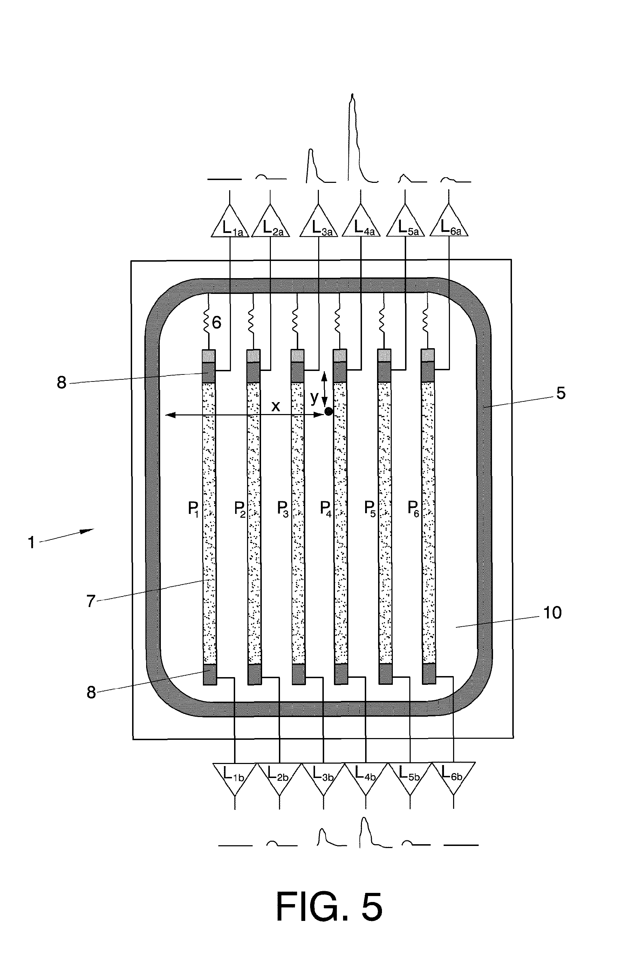

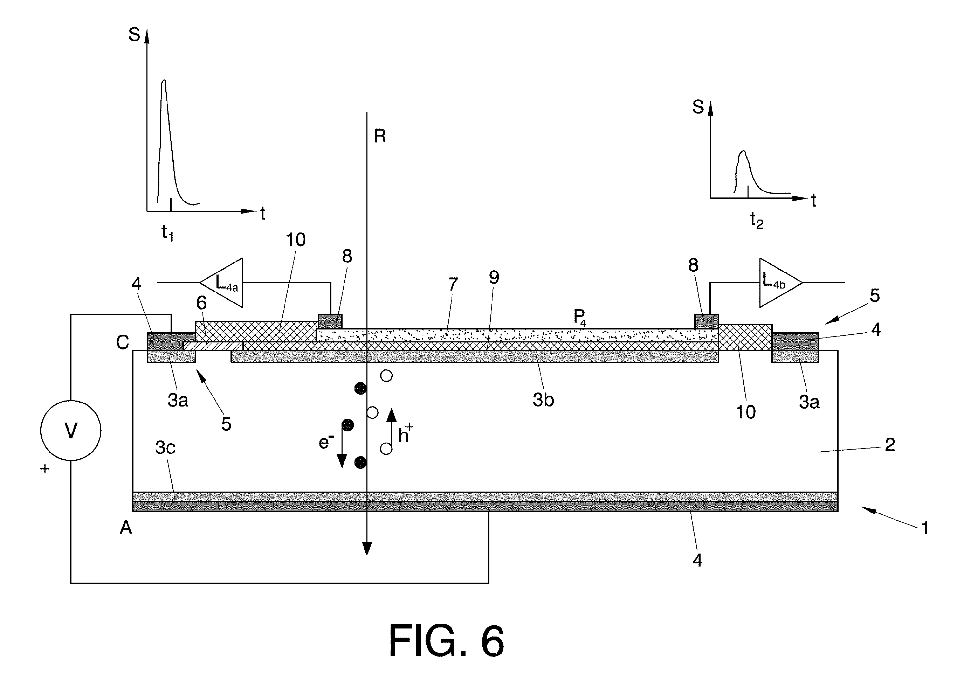

Below an example of a radiation detector (1) in accordance with the present invention is described with reference to the attached figures 5 and 6. Figures 5 and 6 relate to the case of AC coupling (alternating current) of the electrodes with the electronic of reading, which is the typical configuration in the detectors of microtracks of the prior art due to the advantage of decoupling the detection signal from the leakage current, thus reducing the electronic noise. However, it is understood that the DC coupling (direct current) is also possible and can be used in this invention. Similarly, while in this description the electrode formed by microtracks is the cathode (C) it is understood that it would also be possible a detector (1) where the electrode formed by microtracks would be the anode (A). In addition, the detector of this example is manufactured from a silica glass block and consequently each microtrack (P₁-P₆) is formed by a doping implantation (3b) plus a resistive coating (7).

Therefore, the detector (1) in this example is composed of a type n (2) silica glass of about 300-500 µm thick with an active area of some cm² and on its top face there are microtracks (P₁-P₆) of about 20-40 µm width, some centimetres in length and a step of between 25 and 100 µm.

The top face of the detector (1) comprises a guard ring (5), formed by a high concentration of boron ions (p-type doping) implant (3a) and a metallic coating (4) surrounding the active area of the detector (1) where the microtracks are located (P₁-P₆), while the implants (3b) of the microtracks (P₁-P₆) are connected by means of resistances (6) to the guard ring (5). The implant (3a) of the guard ring (5) and the implants (3b) of the microtracks (P₁-P₆) have the same doping (type and concentration). Although not shown in the figures, the metallic coating (4) of the guard ring (5) is electrically grounded, so that the microtracks (P₁-P₆) are also electrically grounded through the resistances (6).

The microtracks (P₁-P₆) are formed by a boron implant (3b) coated by a layer of resistive material (7), e.g. doped polycrystalline silicon. At the two ends of each microtrack (P₁-P₆) are arranged metal contacts (8) for the connection with the respective reading electronic circuits (L₁ₐ, L_{1b}-L₆ₐ, L_{6b}). In addition, a thin insulating layer (9), preferably silicon oxide, arranged between the implant (3b) and the resistive coating (7) of the microtracks (P₁-P₆) acts as a capacity, stopping the continuous leakage current before the reading circuits (L₁ₐ, L_{1b},L₆ₐ, L_{6b}). The microtracks (P₁-P₆) are isolated from each other by means of an insulating material (10), preferably silicon oxide. In the case that the doping implant (3b) of the microtracks (P₁-P₆) is of type n⁺ on a type p-volume, the insulating material (10) the insulation will be completed with diffusions or additional p-type implants in the silicon between the tracks.

At the lower face of the detector (1), a doping implant (3c) of a type opposed to that of the microtracks (P₁-P₆) ensures an ohmic contact with the corresponding metal coating (4) to which is connected a voltage source (V) suitable to inversely polarize the device.

The operation of this detector (1) is the following: when a particle of ionizing radiation (R) passes through the active area of the semiconductor crystal (2) of the detector (1) pairs of electrons (e⁻) and holes (h⁺) are produced. These electrons (e⁻) and holes (h⁺), under the influence of the electric field generated by the polarization of the detector (1), move respectively towards the anode (A) and towards the microtracks (P₁-P₆) that constitute the cathodes (C). In each microtrack (P₁-P₆), the intensity of the detected signals depends on their position with regard to the place where the charge was generated.

As shown in the graphs that show the general shape of the signals obtained by each reading circuit (L₁ₐ, L_{1b}-L₆ₐ, L_{6b}) in the upper and lower parts of figure 5, the microtrack (P₄) closest to the event collects the majority of the charges produced and transmits wider signals than other more distant microtracks (P₁, P₂, P₃, P₅, P₆). The evaluation of the intensity of the signal read by each reading circuit (L₁ₐ, L_{1b}-L₆ₐ, L_{6b}) allows reconstructing the position of the event in the direction perpendicular to the tracks (P₁-P₆), or X coordinate. This procedure is similar to procedures carried out in detectors according to the prior art.

However, figures 5 and 6 also show how, by effect of the layer of resistive material (7), the two reading circuits (L₄ₐ, L_{4b}) of track 4 obtain different signals both in shape and in time. The shape and the relative delay in the signals obtained depend on the length of the portion of microtrack (P4) between the contacts (8) and the place where the free charges have been produced at the passage of the particle (R). The same phenomenon can occur on adjacent tracks with lower signals.

Therefore, comparing the relative delay (t₂- t₁) or the difference in shape or intensity, of the signals received by the reading circuits (L₁ₐ, L_{1b}-L₆ₐ, L_{6b}) from the ends of each microtrack (P₁-P₆), it is possible to obtain the second coordinate (Y coordinate, parallel to the tracks) of the position of the passage of the particle (P) with a spatial resolution that depends on the resistivity of the resistive material (7) used.

Therefore, the detector (1) is capable of identifying the passage position of an ionizing particle (R) in a XY plane without the need of using attached electrodes or special electronics: the process of manufacture and the signals reading electronics are the same entity of those used for a microtrack detector of the prior art.

## Claims

1. Ionizing radiation detector (1) sensitive to the 2D position comprising a semiconductor crystal (2) with an electrode on one of the faces thereof, and where the opposite side comprises another electrode formed by a plurality of microtracks (P1-P6), **characterized in that** each microtrack (P₁-P₆) comprises a layer of resistive material (7) and is connected at both ends to reading circuits (L₁ₐ, L_{1b}-L₆ₐ, L_{6b}).

2. Procedure for detection of ionizing radiation in 2D using a detector (1) according to the previous claim, **characterized in that** it comprises obtaining the coordinate parallel to the microtracks (P₁-P₆) from the difference in arrival times of the signals collected by reading circuits (L₁ₐ, L_{1b}-L₆ₐ, L_{6b}) connected to opposite ends of a microtrack (P₁-P₆).

3. Procedure for detection of ionizing radiation in 2D using a detector (1) according to the previous claim, **characterized in that** it includes obtaining the coordinate parallel to the microtracks (P₁-P₆) from the difference in shape or amplitude of the signals collected by reading circuits (L₁ₐ, L_{1b}, L₆ₐ, L_{6b}) connected to opposite ends of a microtrack (P₁-P₆).
